## Europäisches Patentamt

(19) **European Patent Office**

Office européen des brevets

(11) Veröffentlichungsnummer: **0 044 526**
**B1**

(12) **EUROPÄISCHE PATENTSCHRIFT**

(45) Veröffentlichungstag der Patentschrift:
**29.06.83**

(51) Int. Cl.³: **C 03 B 37/025**

(21) Anmeldenummer: **81105574.8**

(22) Anmeldetag: **15.07.81**

(54) **Verfahren zum Herstellen einer Schicht aus Glas auf einer Innenfläche eines Hohlkörpers.**

(30) Priorität: **21.07.80 DE 3027592**

(43) Veröffentlichungstag der Anmeldung:
**27.01.82 Patentblatt 82/4**

(45) Bekanntmachung des Hinweises auf die Patenterteilung:
**29.06.83 Patentblatt 83/26**

(84) Benannte Vertragsstaaten:
**AT BE CH DE FR GB IT LI NL SE**

(56) Entgegenhaltungen:
**FR-A-2 433 491**

(73) Patentinhaber: **SIEMENS AKTIENGESELLSCHAFT,
Berlin und München Wittelsbacherplatz 2,
D-8000 München 2 (DE)**

(72) Erfinder: **Schneider, Hartmut, Dr, Dipl.-Chem,
Blütenstrasse 12, D-8000 München 40 (DE)**
Erfinder: **Lebetzki, Egon, Riemerschmidtstrasse 32,
D-8000 München 45 (DE)**

## Verfahren zum Herstellen einer Schicht aus Glas auf einer Innenfläche eines Hohlkörpers

Die vorliegende Erfindung bezieht sich auf ein Verfahren zum Herstellen einer Schicht aus Glas auf einer Innenfläche eines Hohlkörpers, bei welchem Verfahren ein zur Glassynthese geeignetes Reaktionsgasgemisch in einen durch Erhitzen des Hohlkörpers von aussen erzeugten heissen Bereich im Inneren des Hohlkörpers eingeleitet und darin zur chemischen Reaktion gebracht wird, wobei ein die Zusammensetzung eines Glases aufweisender Stoff entsteht, der sich auf der Innenfläche als eine Schicht abscheidet, die im heissen Bereich zu einem Glasfilm klargeschmolzen wird.

Ein Verfahren der eingangs genannten Art wird beispielsweise zur Herstellung von hochreinem Glas für die Herstellung von Glasfaserlichtwellenleitern verwendet und ist als CVD-Verfahren bekannt [siehe beispielsweise Survey papers XIth Intern. Congr. Glass, Band II, Prag 1977, S. 144–157; Chem.-Ing. Techn. 51 (1979) S. 612–627 und Appl. Opt. 18 (1979) S. 3684–3693, in der sich auch ein detaillierter Vergleich verschiedener bekannter Herstellungsverfahren findet].

Im allgemeinen wird beim CVD-Verfahren das zur Glassynthese geeignete Reaktionsgasgemisch in ein Glasrohr, das meist aus hochreinem Quarzglas besteht, eingeleitet. Das Reaktionsgasgemisch besteht im allgemeinen aus gasförmigen Halogeniden und aus Sauerstoff. Das Glasrohr wird von aussen durch einen Ofen oder Brenner, beispielsweise einen Wasserstoffbrenner, erhitzt, wodurch im Inneren des Rohres ein heisser Bereich entsteht, der die heisse Innenfläche des Rohres mit umfasst. In diesem heissen Bereich werden die eingeleiteten Halogenide verbrannt. Das entstehende Oxid oder Oxidgemisch sammelt sich in pulvriger oder glasiger Form auf der Innenfläche des Rohres als Schicht, die im heissen Bereich zu einem Glasfilm klargeschmolzen wird. In der Regel werden Brenner verwendet, die nur ein kurzes Stück des Rohres über den ganzen Umfang erhitzen. Zur Beschichtung einer längeren Strecke des Rohres wird der Brenner relativ zum Rohr verschoben, so dass der lokale heisse Bereich im Inneren des Rohres die längere Strecke allmählich durchwandert und dadurch die Innenwand auf dieser Strecke mit synthetischem Glas beschichtet wird. Durch Wiederholung des Beschichtungsprozesses können mehrere übereinander angeordnete Glasschichten auf der Innenfläche des Rohres erzeugt werden. Ein derartig beschichtetes Rohr wird zu einem Stab verformt und damit eine Vorform für Glasfaserlichtwellenleiter gewonnen. Aus dieser stabförmigen Vorform werden Glasfasern gezogen, die die Lichtwellenleiter bilden.

Das CVD-Verfahren führt zu beschichteten Glasrohren bzw. Vorformen besonders hoher Reinheit, aus denen Glasfaser-Lichtwellenleiter hervorragender Qualität, insbesondere mit extrem niedriger Dämpfung bei gleichzeitig hoher Bandbreite gewonnen werden können. Besonders niedrige Dämpfungswerte werden erreicht, wenn das Rohr durch Flammenbeheizung erhitzt wird.

Eine Einschränkung des CVD-Verfahrens ist jedoch in der relativ niedrigen Glasbildungsrate zu sehen. Sie ist um den Faktor 5 bis 15mal kleiner als bei gewissen anderen bekannten Verfahren und führt daher zu entsprechend kleinen Produktionsgeschwindigkeiten. Der Grund für die relativ niedrige Glasbildungsrate ist darin zu sehen, dass beim CVD-Verfahren die Schicht des auf der Innenwand abgeschiedenen Stoffes simultan zum Glas klargeschmolzen bzw. gesintert werden muss. Die Sintergeschwindigkeit bestimmt somit die Glasbildungsrate. Die Sintergeschwindigkeit ist aber begrenzt. Zu schnelles Sintern führt erfahrungsgemäss zu blasigem Glas.

Eine Möglichkeit, die Sintergeschwindigkeit und damit die Glasbildungsrate zu erhöhen, besteht nach Appl. Phys. Lett. 31 (1977) S. 174–176 darin, der in das Rohr eingeleiteten Gasmischung Helium beizufügen. Damit sollen sich fünffach dickere Pulverschichten durchschmelzen lassen, als es bei herkömmlicher Gaszusammensetzung möglich ist.

Aufgabe der vorliegenden Erfindung ist es, aufzuzeigen, wie bei einem Verfahren der eingangs genannten Art die Glasbildungsrate auf andere Weise wirksam erhöht werden kann.

Diese Aufgabe wird dadurch gelöst, dass in den heissen Bereich im Inneren des Hohlkörpers zusätzlich eine brennbare Heizgasmischung eingeleitet wird, die sich in dem heissen Bereich entzündet und darin verbrennt.

Ein wesentlicher Vorteil dieser Lösung ist darin zu sehen, dass nicht nur sehr hohe Sintergeschwindigkeiten und Glasbildungsraten – gegenüber dem herkömmlichen CVD-Verfahren konnten fünfmal grössere Glasbildungsraten erzielt werden – erreicht werden, sondern dass auch die erzeugten dickeren Glasschichten dieselbe Güte aufweisen, wie sie beim herkömmlichen CVD-Verfahren erreicht wird.

Die an der heissen Innenwand entzündete und im Inneren des Rohres verbrennende Heizgasmischung unterstützt die indirekte Beheizung der abgeschiedenen Schicht von aussen wirkungsvoll. Eine Überheizung eines Glasrohres bedingt durch die geringe thermische Leitfähigkeit der Rohrwandung sowie der abgeschiedenen Schicht selbst, wird dadurch vermieden.

Die Erhöhung der Temperatur des Reaktionsgasgemisches durch das Verbrennen des Heizgasgemisches im Rohr beeinflusst den Umsetzungsgrad der chemischen Reaktion des Reaktionsgases und auch die Effizienz der Abscheidung auf der Innenfläche des Rohres günstig. Die hohe Glasbildungsrate, die mit dem Verfahren erreichbar ist, gleicht hohen Glasbildungsraten, wie sie bisher beim Abscheiden auf Stirnflächen von Stäben durch zeitliche Trennung von Abscheidungs- und Sinterprozess voneinander erzielt werden konnten.

Ein weiterer grosser Vorteil des Verfahrens liegt darin, dass die durch die hohe Abscheiderate bedingte dicke Schicht auf der Innenfläche des Hohlkörpers vollständig durchgeschmolzen werden kann, wodurch einzelne Glasfilme und damit Glasschichten grosser Dicke erzeugt werden können. Das Verfahren eignet sich daher besonders zur Herstellung dicker Vorformen für Glasfaserlichtwellenleiter.

Bevorzugterweise wird eine wasserstofffreie Heizgasmischung verwendet. Dadurch lässt sich eine besonders gute optische Qualität des synthetischen Glases erreichen. Als zweckmässig hat es sich dabei erwiesen, wenn die Heizgasmischung Kohlenmonoxid (CO), Dizyan ($C_2N_2$), Schwefelkohlenstoff ($CS_2$), Dizyanazethylen ($C_4N_2$), Kohlenoxidsulfid (COS) und/oder Kohlensuboxid ($C_3O_2$) als zu verbrennendes Gas und Sauerstoff ($O_2$) aufweist.

Es kann auch eine Heizgasmischung verwendet werden, die ein mit Chlor gemischtes wasserstoffhaltiges Gas aufweist, und die beim Verbrennen Chlorwasserstoff anstelle von Wasser liefert.

Unter Umständen ist auch eine Heizgasmischung geeignet, die einen oder mehrere deuterierte Kohlenwasserstoffe als zu verbrennendes Gas aufweist. Bevorzugterweise weist in diesem Fall die Heizgasmischung Tetradeuteromethan und/oder Dideuteroazethylen auf.

Wie schon erwähnt, wird beim herkömmlichen CVD-Verfahren durch lokales Erhitzen des Glasrohres ein lokaler heisser Bereich im Inneren des Rohres erzeugt, der relativ zum Rohr verschoben wird. Bevorzugterweise wird diese Methode auch beim vorliegenden Verfahren verwendet, d.h. dass im Inneren des Hohlkörpers ein lokaler heisser Bereich erzeugt wird, der eine gewisse Strecke durchwandert.

Besonders vorteilhaft ist es, wenn der Heizgasmischung ein als Flammeninhibitor wirkender Stoff beigemischt ist. Dadurch kann erreicht werden, dass die Heizgasmischung nur im heissen Bereich im Inneren des Hohlkörpers verbrennt. Ausserdem wird dadurch ein unter Umständen gefährliches Zurückschlagen der Flamme aus dem heissen Bereich vermieden, das dazu führen kann, dass die Heizgasmischung ausserhalb des Hohlkörpers verbrennt und/oder den heissen Bereich im Inneren des Rohres gar nicht mehr erreicht. Insbesondere bei wanderndem, lokalem heissen Bereich ist die Beimischung eines als Flammeninhibitor wirkenden Stoffes angebracht. Die Flamme des verbrennenden Heizgasgemisches bleibt auf den lokalen heissen Bereich beschränkt, wandert mit diesem mit, und zudem werden sehr gleichmässige Schichtdicken bei den einzelnen Glasschichten erreicht.

Ein als Flammeninhibitor wirkender Stoff weist bevorzugterweise ein gasförmiges Halogenid auf.

Insbesondere ist bekannt, dass Chlorverbindungen als Flammeninhibitoren wirken. Beim herkömmlichen CVD-Verfahren werden im allgemeinen Chlorverbindungen, wie beispielsweise Siliziumtetrachlorid oder Germaniumtetrachlorid für die Reaktionsgasmischung verwendet. Diese Verbindungen wirken als Flammeninhibitoren und können daher als solche der Heizgasmischung beigemischt werden.

Dies hat zu der Erkenntnis geführt, dass als Flammeninhibitor wirkender Stoff einer der Reaktionspartner der Reaktionsgasmischung verwendet werden kann, und dass es vorteilhaft und zweckmässig ist, die Reaktions- und Heizgasmischung miteinander vermischt in den heissen Bereich im Inneren des Hohlkörpers einzuleiten. Dabei reicht es aus, wenn die Reaktions- und Heizgasmischung bereits miteinander vermischt in den Hohlkörper eingeleitet werden.

Die Erfindung wird in der nun folgenden Beschreibung beispielhaft erläutert.

Es wurden mehrere Quarzglasrohre von 600 mm Länge beschichtet. Die Rohre wiesen einen Aussendurchmesser von 20 oder 30 mm und einen Innendurchmesser von 17 bzw. 28 mm auf.

Zum Beschichten wurde ein Rohr in eine Glasdrehbank waagerecht eingespannt. Zum Beheizen des Rohres von aussen wurde ein Wasserstoffbrenner verwendet, der das mit einer Drehzahl von 1 Umdrehung pro Sekunde um seine Längsachse sich drehende Rohr über den ganzen Umfang erhitzt. Der Brenner wurde mit einer Vorschubgeschwindigkeit von 15 cm/min in Längsrichtung des Rohres verschoben. Die Temperatur des heissen Rohres wurde mit einem IR-Strahlungspyrometer abgefühlt und über geregelte Brenngasdosierventile auf 1560 bis 1800°C ± 0,3% konstant gehalten. Als Reaktionsgasmischung wurden $SiCl_4$-Gas, $GeCl_4$-Gas und $O_2$-Gas und als Heizgasmischung CO-Gas und $O_2$-Gas verwendet. Die Reaktionsgas- und Heizgasmischung wurden miteinander vermischt von einer Seite her in das Rohr eingeleitet. Die Strömungsgeschwindigkeit der Gasmischung und damit ihre Durchflussrate durch das Rohr konnte über den Druck der Gasmischung geregelt werden.

Die Reaktionsgasmischung wurde durch Durchperlen geregelter Sauerstoffströme durch thermostatisierte Verdampfergefässe hergestellt. Diese Gefässe waren so dimensioniert, dass eine etwa 100%ige Beladung der Sauerstoffströme mit Dampf erfolgte. Die Beladung wurde vorher für kleine $O_2$-Ströme von höchstens 100 Nml/min durch Auswägen der Gewichtszunahme zweier nachgeschalteter Natronlauge-Waschflaschen festgestellt.

Für die Reinheit der Heizgasmischung gelten dieselben Kriterien wie für die Reaktionsgasmischung. Sie muss der Qualität des synthetischen Glases so rein wie möglich sein. Das $O_2$-Gas der Heiz- und Reaktionsgasmischung wurde ein und derselben Quelle entnommen. Als CO-Gas wurde ein im Handel erhältliches Gas verwendet, welches eine Reinheit von 99,997% aufwies (lieferbar von der Fa. Linde, München).

Auf diese eben beschriebene Weise wurden insgesamt 30 Quarzglasrohre auf der Innenseite mit mehreren Glasschichten beschichtet. Die Ergebnisse sind in der folgenden Tabelle 1) zusammengestellt. In der Tabelle bedeuten: $V(O_2)$, $V(CO)$, $V(SiCl_4)$, $V(GeCl_4)$ der Reihe nach die Durchflussrate des $O_2$-, CO-, $SiCl_4$- bzw. $GeCl_4$-Gases durch das Rohr. $\Sigma V$ bedeutet die Gesamtdurchflussrate der gesamten Gasmischung durch das Rohr. Die Durchflussraten sind in ml/min angegeben. Y bedeutet einen Stöchiometrieparameter, der definiert ist durch $Y = X(O_2)/$

$(X(SiCl_4) + X(GeCl_4) + X(CO)/2)$, wobei X(i) mit i $= O_2$, $SiCl_4$, $GeCl_4$ bzw. CO den Molenbruch des in der Klammer stehenden Gases bedeutet. $Y > 1$ bedeutet Sauerstoffüberschuss, $Y < 1$ Sauerstoffmangel und $Y = 1$ eine stöchiometrische Gasmischung, bei der bekanntlich eine Verbrennung am heissesten ist. 1 gibt die Anzahl der erzeugten einzelnen Glasschichten im betreffenden Rohr an und Vf die tatsächlich erzielte Glasbildungsrate, gemessen in $cm^3/min$.

**Tabelle 1**

| | Nml/min | | | | | | | | $cm^3/min$ |
|---|---|---|---|---|---|---|---|---|---|
| Nr. | $V(O_2)$ | $V(CO)$ | $V(SiCl_4)$ | $V(GeCl_4)$ | $\Sigma V$ | Y | $X(SiCl_4)$ | 1 | $V_f$ |
| 1 | 1056 | 0 | 90 | 21 | 1170 | 9,51 | 0,077 | 10 | 0,061 |
| 2 | 1056 | 50 | 90 | 21 | 1220 | 7,77 | 0,074 | 10 | 0,059 |
| 3 | 4210 | 0 | 90 | 21 | 4320 | 37,9 | 0,021 | 6 | 0,040 |
| 4 | 4210 | 640 | 90 | 21 | 4960 | 9,76 | 0,018 | 6 | 0,037 |
| 5 | 2710 | 0 | 90 | 21 | 2820 | 24,4 | 0,032 | 6 | 0,047 |
| 6 | 2710 | 640 | 90 | 21 | 3460 | 6,28 | 0,026 | 6 | 0,043 |
| 7 | 2710 | 940 | 90 | 21 | 3750 | 4,66 | 0,024 | 6 | 0,037 |
| 8 | 2710 | 1870 | 90 | 21 | 4690 | 2,58 | 0,019 | 3 | 0,036 |
| 9 | 2710 | 2200 | 430 | 110 | 5440 | 1,65 | 0,079 | 5 | 0,093 |
| 10 | 2710 | 2200 | 860 | 220 | 5980 | 1,24 | 0,144 | 5 | 0,161 |
| 11 | 3000 | 2200 | 860 | 0 | 6060 | 1,53 | 0,142 | 9 | – |
| 12 | 3000 | 2200 | 860 | 700 | 6760 | 1,13 | 0,127 | 10 | 0,169 |
| 13 | 3500 | 2100 | 840 | 420 | 6960 | 1,52 | 0,121 | 3 | 0,169 |
| 14 | 3000 | 2100 | 840 | 420 | 6360 | 1,30 | 0,132 | 3 | 0,171 |
| 15 | 2500 | 2100 | 840 | 420 | 5860 | 1,08 | 0,143 | 3 | 0,180 |
| 16 | 1750 | 1050 | 420 | 210 | 3430 | 1,52 | 0,122 | 3 | 0,118 |
| 17 | 1500 | 1050 | 420 | 210 | 3180 | 1,30 | 0,132 | 3 | 0,119 |
| 18 | 1250 | 1050 | 420 | 210 | 2930 | 1,08 | 0,143 | 3 | 0,154 |
| 19 | 980 | 660 | 420 | 140 | 2200 | 1,1 | 0,191 | 3 | 0,155 |
| 20 | 840 | 402 | 420 | 140 | 1800 | 1,1 | 0,233 | 3 | 0,160 |
| 21 | 695 | 144 | 420 | 140 | 1400 | 1,1 | 0,300 | 3 | 0,169 |
| 22 | 950 | 690 | 420 | 140 | 2200 | 1,05 | 0,191 | 3 | 0,162 |
| 23 | 920 | 720 | 420 | 140 | 2200 | 1,0 | 0,191 | 3 | 0,163 |
| 24 | 890 | 754 | 420 | 140 | 2200 | 0,95 | 0,191 | 3 | 0,161 |
| 25 | 1590 | 1100 | 840 | 56 | 3580 | 1,1 | 0,25 | 3 | 0,220 |
| 26 | 2647 | 1385 | 1260 | 84 | 5380 | 1,3 | 0,25 | 3 | 0,265 |
| 27 | 3176 | 2200 | 1260 | 84 | 6720 | 1,3 | 0,20 | 3 | 0,255 |
| 28 | 1032 | 0 | 140 | 28 | 1200 | 6,1 | 0,117 | 2 | 0,085 |
| 29 | 2650 | 1385 | 1260 | 0 | 5300 | 1,4 | 0,238 | 12 | 0,273 |
| 30 | 1000 | 0 | 28 | 4 | 1032 | 31 | 0,027 | 6 | – |

Rohrdurchmesser bei Rohren 25 bis 28 aussen 30 mm, innen 28 mm; sonst aussen 20 mm, innen 17 mm.

Aus der Tabelle 1 kann als wichtigstes Ergebnis abgelesen werden, dass Glasbildungsraten $V_f$ von etwa 0,27 $cm^3/min$ erreicht werden konnten, und zwar bei Rohr Nr. 26 und Rohr Nr. 29. Ausserdem zeigt die Tabelle 1, dass die Glasbildungsrate mit der Durchflussrate $V(SiCl_4)$ des Siliziumtetrachloridgases wächst und mit steigender Gesamtdurchflussrate $\Sigma V$ sinkt.

Es wurden auch noch folgende Beobachtungen gemacht: Nur für $Y < 1,5$ war es möglich, blasenfreie Glasschichten bei hohen Glasbildungsraten zu erzielen. Der Molenbruch $X(SiCl_4)$ für Siliziumtetrachloridgas dürfte den Wert 0,25 nicht überschreiten, da sonst $SiCl_4$ bei Raumtemperatur im Leitungssystem auskondensiert. Die $SiO_2$-Glasausbeute $\eta$ sank sowohl mit der Durchflussrate $V(SiCl_4)$ als auch mit der Gesamtdurchflussrate $\Sigma V$ ab. Die Glasausbeute $\eta$ ist dabei definiert durch

$$\eta = V_f/V_{f,M},$$

wobei

$$V_{f,M} = V(SiCl_4) \cdot \varrho(SiCl_4) \cdot \frac{M(SiO_2)}{\varrho(SiO_2)} \cdot \frac{1}{M(SiCl_4)}$$

die maximal mögliche Glasbildungsrate bedeutet. In dieser Formel bedeuten $\varrho(SiCl_4)$ bzw. $\varrho(SiO_2)$ die Dichten und $M(SiCl_4)$ bzw. $M(SiO_2)$ die Molmassen von $SiCl_4$ bzw. $SiO_2$. Die naheliegende Vermutung, dass das Absinken der Ausbeute mit steigender Gesamtdurchflussrate $\Sigma V$ durch die zunehmende lineare Gasgeschwindigkeit im Rohr verursacht wird, hat sich nicht bestätigt. Die Ursachen dafür sind anderswo zu suchen. Aus dem Rohr Nr. 10 in Tabelle 1 wurde durch Verformen des Rohres zu einem Stab eine Vorform für eine Multimode-Stufenindex-Profilfaser mit $SiO_2$-Mantel und $SiO_2$-$GeO_2$-Kern hergestellt. Die Vorform hatte eine Länge von etwa 22 cm, einen Gesamtdurchmeser von 10 mm ±1 mm und das Verhältnis zwischen dem Durchmesser des Kerns und dem Gesamtdurchmesser betrug 0,36. Für dieses Verhältnis waren demnach nur 10 statt wie bisher 30 Kernglasschichten erforderlich. Die Brechzahldifferenz zwischen dem Kernglas und dem Mantelglas, die mit einem Abbe-Refraktometer gemessen wurden, betrug 0,035, was einer Germanium-Dioxid-Konzentration im Kern von etwa 4 Gew.% entspricht.

Aus dieser Vorform wurde auf herkömmliche Weise in einem Graphit-Induktionsofen eine Faser von etwa 630 m Länge gezogen. Der Gesamtdurchmesser der Faser betrug etwa 0,125 mm. Das Verhältnis zwischen Kerndurchmesser und Gesamtdurchmesser betrug wie bie der Vorform 0,36 und die Brechzahldifferenz zwischen Kernglas und Mantelglas blieb mit 0,035 ebenfalls erhalten.

Die Faser zeigte in einem Spektralbereich unterhalb 720 nm eine sehr niedrige Dämpfung. Bei einer Wellenlänge von 630 nm ergab sich eine Dämpfung von 7,0 ±0,4 dB/km, ein äusserst niedriger Wert, wenn nicht der niedrigste Dämpfungswert, der bisher an einer Multimode-Glasfaser beobachtet werden konnte.

Weitere Messungen an der Faser wiesen darauf hin, dass das Fasermaterial eine ausgezeichnete Homogenität besitzt – der an der Faser gemessene Streukoeffizient A war mit 1,1 $\mu m^4$ dB/km extrem niedrig.

Das Kernmaterial der Faser erwies sich als frei von Beimischungen mit Absorptionsbanden im sichtbaren oder starken Absorptionsbanden im ultravioletten Spektralbereich.

Aus dem innenbeschichteten Rohr Nr. 29 in Tabelle 1 wurde eine stabförmige Vorform für eine Monomodefaser hergestellt. Dabei wurden die zwölf abgeschiedenen Schichten aus $SiO_2$-Glas für das Mantelglas der Faser verwendet. Auf diese zwölf Schichten wurde nach dem herkömmlichen CVD-Verfahren, also ohne zusätzliche Innenheizung, ein $GeO_2$-dotiertes $SiO_2$-Glas als Kernglas abgeschieden. Bei Herstellung der Mantelglasschichten nach dem herkömmlichen CVD-Verfahren ohne Innenheizung hätten anstelle von zwölf Schichten sechzig Schichten abgeschieden werden müssen, um eine für dämpfungsarme Lichtführung ausreichende Manteldicke zu erzielen.

Aus dem in beschriebener Weise beschichteten Rohr wurde durch Verformen des Rohres zum Stab die Vorform für die Monomode-Faser gewonnen. Sie hatte eine Länge von etwa 27 cm, der Manteldurchmesser betrug 10,3 ±0,1 mm, das Verhältnis zwischen Kerndurchmesser und Manteldurchmesser betrug 0,080 ±0,008 und die Brechzahldifferenz zwischen Kernglas und Mantelglas 0,039. Letztere wurde mit einer Elektronenmikrosonde gemessen.

Aus dieser Vorform wurde mittels eines Graphit-Widerstandsofens mit Zirkonoxid-Muffelrohr eine Faser von etwa 305 m Länge und 0,080 mm Manteldurchmesser gezogen. Das Verhältnis zwischen Kerndurchmesser und Manteldurchmesser sowie die Brechzahldifferenz hatten dieselben Werte wie bei der Vorform.

Aus dieser Vorform wurde auch eine Faser von etwa 213 m Länge gezogen, die einen geringeren Manteldurchmesser von 0,070 mm aufwies. Das Verhältnis zwischen Kerndurchmesser und Manteldurchmesser und die Brechzahldiffrenz zwischen Kernglas und Mantelglas hatten dieselben Werte wie bei der Vorform.

Beide Fasern hatten Monomode-Eigenschaften. Das Dämpfungsminimum beider Fasern wurde zwischen 700 und 800 nm gemessen und betrug 3 dB/km. Die dickere der beiden Fasern erwies sich als lichtdurchlässiger.

Bei der Messung der Impulsantwort erwies es sich, dass die dickere der beiden Fasern nach 300 m, die dünnere nach 200 m Faserlänge nur noch den Grundmodus führt.

Alle drei hergestellten Fasern wurden im übrigen noch mit einem Kunststoffmantel versehen und sämtliche Messungen an den Fasern wurden an den kunststoffbeschichteten Fasern durchgeführt.

### Patentansprüche

1. Verfahren zum Herstellen einer Schicht aus Glas auf einer Innenfläche eines Hohlkörpers, bei welchem Verfahren ein zur Glassynthese geeignetes Reaktionsgasgemisch in einem durch Erhitzen des Hohlkörpers von aussen erzeugten heissen Bereich im Inneren des Hohlkörpers eingeleitet und darin zur chemischen Reaktion gebracht wird, wobei ein die Zusammensetzung eines Glases aufweisender Stoff entsteht, der sich auf der Innenfläche als eine Schicht abscheidet, die im heissen Bereich zu einem Glasfilm klargeschmolzen wird, dadurch gekennzeichnet, dass in den heissen Bereich im Inneren des Hohlkörpers zusätzlich eine brennbare Heizgasmischung eingeleitet wird, die sich in dem heissen Bereich entzündet und darin verbrennt.

2. Verfahren nach Anspruch 1, dadurch gekennzeichnet, dass eine wasserstofffreie Heizgasmischung verwendet wird.

3. Verfahren nach Anspruch 2, dadurch gekennzeichnet, dass die Heizgasmischung CO, $C_2N_2$, $CS_2$, $C_4N_2$, COS und/oder $C_3O_2$ als zu verbrennendes Gas und $O_2$ aufweist.

4. Verfahren nach Anspruch 1, dadurch gekennzeichnet, dass die Heizgasmischung ein halogen- und wasserstoffhaltiges Gas aufweist, das beim Verbrennen Halogenwasserstoff anstelle von Wasser liefert.

5. Verfahren nach Anspruch 1 oder 4, dadurch gekennzeichnet, dass die Heizgasmischung einen oder mehrere deuterierte Kohlenwasserstoffe als zu verbrennendes Gas aufweist.

6. Verfahren nach Anspruch 5, dadurch gekennzeichnet, dass die Heizgasmischung Tetradeuteromethan und/oder Dideuteroazethylen als zu verbrennendes Gas aufweist.

7. Verfahren nach einem der vorhergehenden Ansprüche, dadurch gekennzeichnet, dass der Heizgasmischung ein als Flammeninhibitor wirkender Stoff beigemischt ist.

8. Verfahren nach Anspruch 7, dadurch gekennzeichnet, dass ein als Flammeninhibitor wirkender Stoff ein gasförmiges Halogenid aufweist.

9. Verfahren nach einem der vorhergehenden Ansprüche, insbesondere nach Anspruch 8, dadurch gekennzeichnet, dass die Reaktions- und Heizgasmischung miteinander vermischt in den heissen Bereich im Inneren des Hohlkörpers eingeleitet wird.

## Claims

1. A process for the production of a layer of glass on an inner surface of a hollow body, in which a reaction gas mixture, which is suitable for synthesizing the glass, is introduced into a hot region within the hollow body, which is produced by heating the hollow body from the outside, and is caused to react chemically therein, whereby a material is produced which has the composition of a glass and which is deposited on the inner surface as a layer which in the hot region is melted until clear to form a glass film, characterised in that a combustible heating gas mixture is additionally introduced into the hot region within the hollow body, which heating gas mixture ignites and burns in the hot region.

2. A process as claimed in Claim 1, characterised in that a heating gas mixture which is free from hydrogen is used.

3. A process as claimed in Claim 2, characterised in that the heating gas mixture comprises $CO$, $C_2N_2$, $CS_2$, $C_4N_2$, $COS$ and/or $C_3O_2$, as the combustion gas and $O_2$.

4. A process as claimed in Claim 1, characterised in that the heating gas mixture comprises a halogen- and hydrogen-containing gas, which on burning, supplies hydrogen halide in place of water.

5. A process as claimed in Claim 1 or Claim 4, characterised in that the heating gas mixture comprises one or more deuterized hydrocarbons as combustion gas.

6. A process as claimed in Claim 5, characterised in that the heating gas mixture comprises tetradeuteromethane and/or dideuteroacetylene as combustion gas.

7. A process as claimed in one of the preceding Claims, characterised in that a substance acting as a flame inhibitor is added to the heating gas mixture.

8. A process as claimed in Claim 7, characterised in that, a gaseous halide serves as the substance acting as a flame inhibitor.

9. A process as claimed in one of the preceding Claims, in particular as claimed in Claim 8, characterised in that the reaction gas mixture and heating gas mixture are introduced into the hot region within the hollow body in admixture.

## Revendications

1. Procédé pour déposer une couche de verre sur la face interne d'un corps creux, procédé qui consiste à envoyer à l'intérieur du corps creux dans une région chaude, obtenue par chauffage du corps creux de l'extérieur, un mélange de gaz de réaction qui convient pour la synthèse du verre et à l'y faire réagir chimiquement, en formant une substance, présentant la composition du verre, qui se dépose sur la face interne en une couche qui est fondue dans la région chaude en une pellicule de verre à l'état limpide, caractérisé en ce qu'il consiste à envoyer en plus dans la région chaude à l'intérieur du corps creux un mélange combustible de gaz de chauffage qui s'enflamme dans la région chaude et y brûle.

2. Procédé suivant la revendication 1, caractérisé en ce qu'il consiste à utiliser un mélange de gaz de chauffage exempt d'hydrogène.

3. Procédé suivant la revendication 2, caractérisé en ce que le mélange de gaz de chauffage contient $CO$, $C_2N_2$, $CS_2$, $C_4N_2$, $COS$ et /ou $C_3O_3$ comme gaz de combustion et $O_2$.

4. Procédé suivant la revendication 1, caractérisé en ce que le mélange de gaz de chauffage contient un gaz hydrogéné et contenant un halogène qui, par combustion, fournit un halogénure d'hydrogène au lieu d'eau.

5. Procédé suivant la revendication 1 ou 4, caractérisé en ce que le mélange de gaz de chauffage contient un ou plusieurs hydrocarbures deutérés comme gaz de combustion.

6. Procédé suivant la revendication 5, caractérisé en ce que le mélange de gaz de chauffage contient du méthane trétradeutéré et/ou de l'acétylène dideutérée comme gaz de combustion.

7. Procédé suivant l'une des revendications précédentes, caractérisé en ce que le mélange de gaz de chauffage est additionné d'une substance agissant comme inhibiteur de flammes.

8. Procédé suivant la revendication 7, caractérisé en ce qu'une substance agissant comme inhibiteur de flammes contient un halogénure gazeux.

9. Procédé suivant l'une des revendications précédentes, notamment suivant la revendication 8, caractérisé en ce qu'il consiste à envoyer le mélange réactionnel et le mélange de gaz de chauffage mélangés entre eux dans la région chaude à l'intérieur du corps creux.